# EUROPEAN PATENT APPLICATION

(11) **EP 2 555 289 A1**
(43) Date of publication of application: **06.02.2013**
(21) Application number: 11762479.1
(22) Date of filing: 04.03.2011
(51) Int. Cl.: H01M 4/70, C23F 1/02, H01G 9/016

(54) **METAL FOIL FOR NEGATIVE ELECTRODE COLLECTOR**

(30) Priority: 31.03.2010 JP 2010084114
(71) Applicant: Toyo Aluminium Kabushiki Kaisha, Osaka-shi, Osaka 541-0056 (JP)
(72) Inventor: MEHATA, Masashi, Osaka-shi Osaka 541-0056 (JP); KONISHI, Atsushi, Osaka-shi Osaka 541-0056 (JP); MURAMATSU, Kenji, Osaka-shi Osaka 541-0056 (JP)
(74) Representative: Müller-Boré & Partner Patentanwälte
(86) International application number: PCT/JP2011/055035
(87) International publication number: WO 2011/122239

(57) **Abstract**

The main object of the present invention is to provide a metal foil for a negative electrode collector, by which it is possible to achieve a lower resistance value.

The present invention is directed to a metal foil for a negative electrode collector, which has a plurality of openings that reach a foil rear surface from a foil front surface and which has a region having a through hole density of 1000 holes/cm² or more.

## Description

### BACKGROUND OF THE INVENTION

### 1. Field of the Invention

The present invention relates to a novel metal foil for a negative electrode collector. More specifically, the present invention relates to a metal foil for a negative electrode collector that is used as a collector in a lithium ion battery, a lithium ion capacitor, an electrical double layer capacitor and the like.

### 2. Description of the Related Art

In lithium ion batteries, lithium ion capacitors and electrical double layer capacitors and the like, positive electrode collectors are made from aluminum, stainless steel and the like, and negative electrode collectors are made from stainless steel, copper, nickel and the like.

Higher voltages are required in order to improve the energy density in these lithium ion batteries, lithium ion capacitors, electrical double layer capacitors and the like. In order to increase the energy density, it is preferable to use a pre-doping technique and reduce the negative electrode potential. In addition, in order to carry out pre-doping with good efficiency, it is necessary to provide through holes in a collector. That is, it is possible to support lithium ions in a negative electrode active substance by providing through holes in a collector so as to enable reversible transfer of the lithium ions.

Punching, mesh processing, expansion processing, net processing and the like are known as methods for preparing collectors having through holes, but through holes formed using these methods are generally 0.1 to 0.3 mm in size (see Japanese Patent Application Publication No. 2004-103314). However, simply providing through holes reduces the strength of a collector, and through holes having relatively large diameters, such as those mentioned above, exacerbate the problem of reduced strength.

In contrast, proposals have been made for electrodes using collectors having relatively fine through holes. For example, a lithium ion capacitor which is provided with a positive electrode comprising a substance able to reversibly support lithium ions and/or anions and a negative electrode comprising a substance able to reversibly support lithium ions and which is provided with an aprotic organic solvent electrolyte solution of lithium salt as an electrolyte, wherein the capacitor has a collector comprising a metal foil in which (1) the negative electrode and/or positive electrode are doped with lithium ions by electrochemically connecting the negative electrode and/or the positive electrode with a lithium ion supply source, (2) the potential of the positive electrode is 2.0 V or lower after short circuiting the positive electrode and the negative electrode, and (3) the aforementioned positive electrode and/or negative electrode have a multiplicity of through holes between the front and rear surfaces and the average inscribed circle diameter of these through holes is 100 µm or lower, is known (see WO 2008/078777).

In addition, a collector comprising an aluminum etched foil which has a thickness of 20 to 45 µm, an apparent density of 2.00 to 2.54 g/cm³ and an air permeability of 20 to 120 s and which has a multiplicity of through holes between the front and rear surfaces, wherein 80% or more of the aforementioned through holes have hole diameters of 1 to 30 µm, is known as a positive electrode collector used in a lithium ion capacitor such as that mentioned above (see Japanese Patent Application Publication No. 2009-62595).

However, electrodes that use conventional negative electrode collectors have relatively high resistance (internal resistance) for electrodes, which can lead to concerns regarding adverse effects on charging and discharging characteristics when used in batteries and the like. Causes of increased electrode resistance include the state of distribution of through holes in a collector and adhesion between a collector and an active substance, and it is therefore necessary to improve these characteristics.

### SUMMARY OF THE INVENTION

Therefore, the main objective of the present invention is to provide a metal foil for a negative electrode collector, by which it is possible to achieve a lower resistance value.

As a result of diligent research into the problems inherent in the prior art, the inventors of the present invention found that it was possible to achieve the above-mentioned objective by controlling the distribution of through holes within a specified range, and thereby completed the present invention.

That is, the present invention relates to the following metal foil for a negative electrode collector.
1. A metal foil for a negative electrode collector, which has a plurality of openings that reach a foil rear surface from a foil front surface and which has a region having a through hole density of 1000 holes/cm² or more.
2. The metal foil for a negative electrode collector according to 1 above, wherein an average internal diameter of the through holes is 100 µm or lower.
3. The metal foil for a negative electrode collector according to in 1 or 2 above, wherein the aperture ratio of the openings is 30% or lower.
4. The metal foil for a negative electrode collector according to any one of 1 to 3 above, wherein 2.0 > [the foil thickness (µm)/the aperture ratio (%)] > 0.25 is established.
5. The metal foil for a negative electrode collector according to any one of 1 to 4 above, further containing a region having a through hole density of less than 1000 holes/cm².
6. The metal foil for a negative electrode collector according to any one of 1 to 5 above, wherein the area of the region having a through hole density of 1000 holes/cm² or more is 100 mm² or more.

### Advantages of the invention

According to the present invention, by controlling the distribution of through holes within a specified range, it is possible to achieve a lower resistance value than conventional collectors when using the collector in an electrode.

This type of metal foil for a negative electrode collector can be preferably used as a collector for a lithium ion battery, a lithium ion capacitor, and electrical double layer capacitor and the like. In particular, the metal foil for a negative electrode collector of the present invention is useful as a negative electrode collector of a lithium ion capacitor or a lithium ion secondary battery which comprises 1) a positive electrode comprising a substance able to reversibly support lithium ions and/or anions, 2) a negative electrode comprising a substance able to reversibly support lithium ions, and 3) an electrolyte solution that contains lithium ions, and in which the positive electrode and/or negative electrode are doped with lithium ions.

### BRIEF DESCRIPTION OF THE DRAWINGS

FIG. 1 is a diagram showing an example of a process for producing the metal foil of the present invention;
FIG. 2 is a schematic view showing a cross section of a metal foil having through holes;
FIG. 3 is a diagram showing examples of patterns of through hole regions and support regions;
FIG. 4 (a) is a diagram showing an example of a pattern of a through hole region and a support region in a metal foil produced in the examples, and FIG. 4(b) is a diagram showing intervals between formed through holes; and
FIG. 5 is a diagram showing a schematic view of a battery formed in Test Example 2.

### DESCRIPTION OF THE PREFERRED EMBODIMENTS

### 1. Metal foil for a negative electrode collector

The metal foil for a negative electrode collector of the present invention (the metal foil of the present invention) is characterized by having a plurality of through holes that reach the foil rear surface from the foil front surface and having a region having a through hole density of 1000 holes/cm² or more (a through hole region) . That is, the metal foil of the present invention is characterized by having a plurality of through holes that reach the foil rear surface from the foil front surface and having a through hole density of 1,000 holes/cm² or more in a 1 cm² region at an arbitrary location.

The metal used in the metal foil of the present invention can be a material (a metal foil) according to those used in conventional negative electrode collectors for batteries. For example, it is possible to preferably use copper, stainless steel, nickel, aluminum or an alloy containing at least one of these. Of these, it is preferable to use copper from the perspective of electrochemical characteristics as a negative electrode collector. When using copper, it is possible to use a rolled copper foil, an electrolytic copper foil and the like.

In addition, the thickness of the metal foil is not limited, but is generally within the range 3 to 100 µm, and can be set as appropriate according to, for example, the type of metal foil used. For example, when using a copper foil as the metal foil, a thickness of 8 to 25 µm is more preferred.

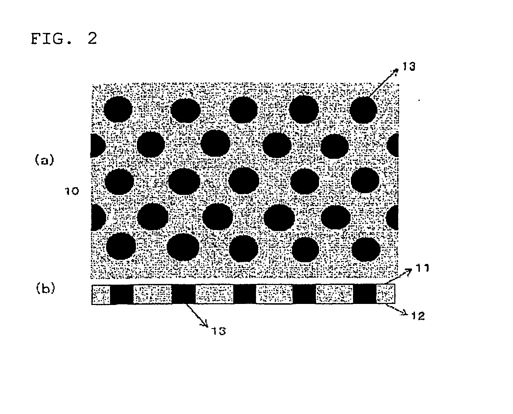

In the present invention, the through holes are holes 13 that penetrate from the front surface 11 to the rear surface 12 of the metal foil 10, as shown in FIG. 2.

As mentioned above, the through hole density is 1000 holes/cm² or higher, preferably 1500 to 30000 holes/cm², and more preferably 2000 to 20000 holes/cm². By setting the through hole density to fall within the above-mentioned range, the distance between through holes is reduced and ions can pass more easily, which therefore contributes to achieving a lower resistance value.

The size of the through holes is also not limited, but the average internal diameter of the through holes is preferably 100 µm or lower, and especially 90 µm or lower. By setting the average internal diameter to fall within the above-mentioned range, it is possible to more evenly control the thickness of a coating film when an active substance (slurry) is coated on the metal foil of the present invention. In the present invention, the average internal diameter of the through holes means the diameter calculated from the average area of the through holes, on the assumption that the through holes are circles.

The aperture ratio in the metal foil of the present invention is generally 40% or lower, and preferably 30% or lower. In the prior art, the aperture ratio was set to a higher value in order for ions to pass through the collector more easily, but a larger aperture ratio resulted not only in a reduction in foil strength, but also made it difficult to evenly coat an active substance on the foil, resulted in the active substance inside the through holes shrinking during drying after coating, and led to the active substance peeling or cracking more readily. In contrast, by setting the aperture ratio of the metal foil of the present invention to fall within the above-mentioned range, it is possible to maintain a higher foil strength. In the present invention, the aperture ratio is the ratio of the total area occupied by openings of through holes relative to the overall area of the region containing through holes on the surface of the metal foil.

In addition, it is preferable for the foil thickness and aperture ratio of the metal foil of the present invention to satisfy the relationship:
2.0> [the foil thickness (µm) /the aperture ratio (%) ] > 0.25. It is particularly preferable for 1.8 ≥ [the foil thickness (µm)/the aperture ratio (%)] ≥ 0.27. If the above-mentioned value is 0.25 or lower, there are concerns that the strength of the foil will significantly deteriorate. However, if the above-mentioned value is 2.0 or higher, this causes problems such as the pre-doping time increasing.

The metal foil of the present invention may contain a region other than a through hole region. That is, the metal foil of the present invention may contain a region having a through a hole density of less than 1000 holes/cm² (preferably 500 holes/cm² or lower, more preferably 100 holes/cm² or lower, and most preferably 0 holes/cm²) (hereinafter referred to as a "support region") . If the metal foil of the present invention contains a support region, the support region acts to support the through hole region, and it is therefore possible to effectively maintain the strength of the overall metal foil.

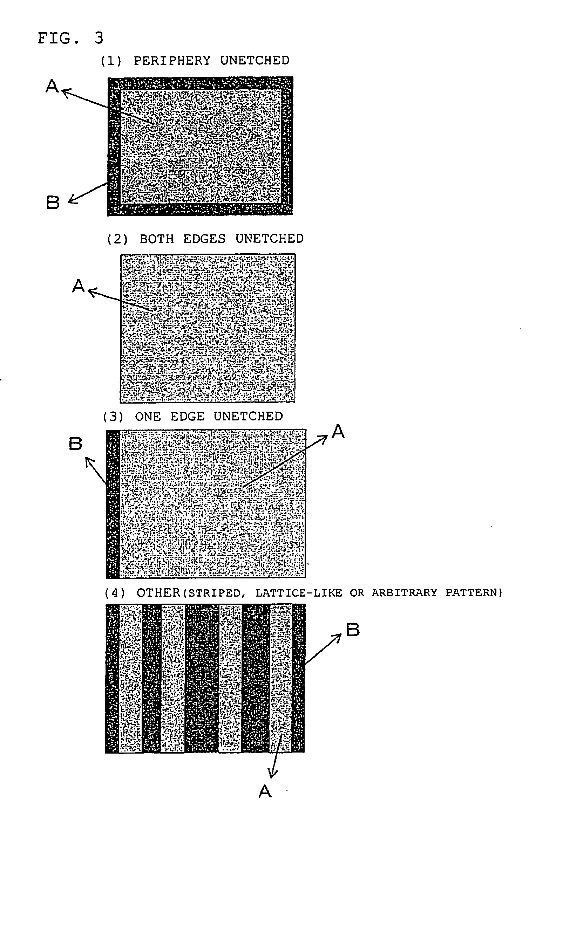

The area and pattern of the support region can be set as appropriate according to, for example, the thickness, material and intended use of the metal foil of the present invention. For example, as shown in FIG. 3, it is possible to obtain 1) a pattern whereby a support region is provided around the periphery of a rectangular through hole region, 2] a pattern whereby a support region is provided at one edge of a rectangular through hole region, 3) a pattern whereby support regions are provided at both edges of a rectangular through hole region, or 4) a pattern whereby through hole regions and support regions are provided alternately in a striped pattern. In such cases, the areal ratio of the through hole region(s) and support region (s) is not limited, and can be set as appropriate according to the desired battery characteristics and the like. In particular, it is preferable for the total area of through hole regions to be 100 mm² or more in the present invention. 2. Method for producing metal foil for negative electrode collector

The metal foil of the present invention can be produced using a publicly known method except that the through hole density and the like is controlled within a prescribed range. For example, it is possible to obtain the metal foil of the present invention by etching a metal foil having a prescribed thickness.

As a method for etching, it is possible to preferably use a method that includes, for example, 1) a step of forming a photoresist film on the surface of a metal foil (a photoresist film formation step), 2) a step of exposing the photoresist film to UV light via a photomask (an exposure step), 3) a step of removing a prescribed pattern part from the photoresist film by developing (a developing step), 4) a step of forming through holes in the metal foil by etching (an etching step), and 5) a step of removing the remaining photoresist film (a peeling step).

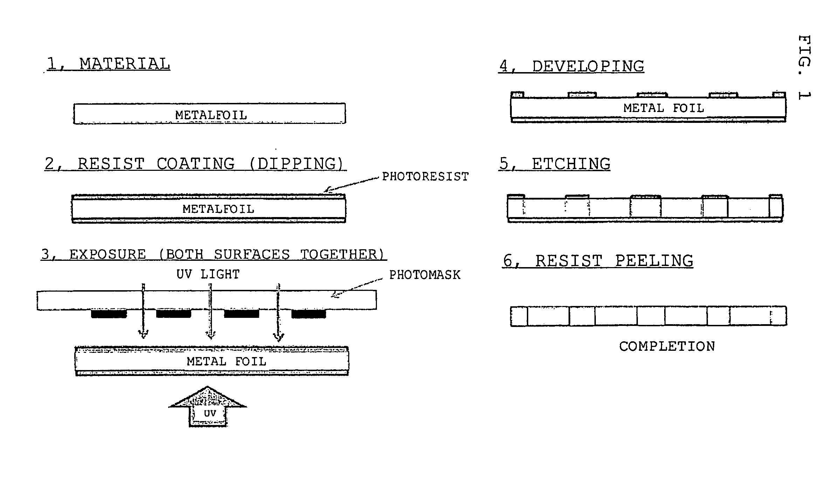

The above-mentioned method will now be explained with reference to FIG. 1. FIG. 1 is a schematic cross sectional view showing the order of steps for forming through holes in a metal foil for a collector according to one embodiment of the production method of the present invention.

### Metal foil

Firstly, a metal foil in which through holes are to be formed is prepared as shown in "1, Material" in FIG. 1. The metal foil is not particularly limited as long as etching with an acid or alkali is possible and the metal foil can be used as a collector for a secondary battery. This type of metal foil can generally be an aluminum foil, an aluminum alloy foil, a copper foil, a stainless steel foil, a nickel foil and the like. The thickness of the metal foil is not limited, but is generally 3 to 100 µm, and preferably 8 to 50 µm. If the thickness of the metal foil is less than 3 µm, the strength of the metal foil is extremely low and the metal foil easily breaks during the collector production process. However, if the thickness of the metal foil exceeds 100 µm, the weight of the ultimately obtained secondary battery increases.

In addition, it is possible to use not only one type of metal foil or alloy foil, but also a clad foil comprising the same types of metal or alloy. In cases where an aluminum foil or aluminum alloy foil is used as the metal foil, the components of the aluminum or aluminum alloy can be selected as appropriate from among pure aluminum (JIS 1000 type), an aluminum-manganese (Al-Mn)-based alloy (JIS 3000 type), an aluminum-magnesium (Al-Mg)-based alloy (JIS 5000 type), and aluminum-iron (A1-Fe)-based alloy (JIS 8000 type) and the like according to the type of electrolyte in the secondary battery.

### Photoresist film formation step

Next, a photoresist film is formed on the surface of the metal foil in the photoresist film formation step shown in "2, Resist coating" in FIG. 1. The photoresist film formation can be carried out using known methods, such as 1) a method of printing or coating a solution or dispersion of a synthetic resin on the metal foil, 2) a method of dipping the metal foil in a solution or dispersion of a synthetic resin, or 3) a method of laminating a pre-formed synthetic resin on the metal foil. If a printing method is used, it is possible to use, for example, gravure printing, transfer printing or screen printing. In addition, in cases where a solution or dispersion of a synthetic resin is used, as mentioned above, drying can generally be carried out at a temperature of 30 to 150°C for a period of between 10 seconds and 10 minutes.

The synthetic resin can be one known as a photoresist film. For example, it is possible to use an acrylic resin, polyethylene terephthalate, polypropylene, polyethylene and the like. In the present invention, an acrylic resin is preferably used. More specifically, it is preferable to use a negative resist formed from an acrylic resin.

The thickness of the photoresist film formed on the metal foil can be set as appropriate according to the type of synthetic resin used, but can generally be 1 to 50 µm.

The photoresist film may be formed on one or both sides of the metal foil. In the present invention, it is particularly preferable to form a photoresist film on both surfaces of the metal foil. That is, if a photoresist film is formed on both surfaces, as shown in FIG. 1, it is possible to cure the entire photoresist film on the rear surface by irradiating the entire rear surface with UV light, thereby enabling the pitch of the through holes to be stabilized.

### Exposure step

The photoresist film is exposed to UV light via a photomask in the exposure step shown in "3, Exposure" in FIG. 1. The period of exposure to UV light (the irradiation time) and the intensity of the UV light canbe set in accordance with conventional methods. A photomask may be used on one or both surfaces of the metal foil, but in view of stabilizing the pitch of the through holes and simplifying the equipment, it is preferable to use a photomask on one surface of the metal foil. That is, it is preferable for a photoresist film to be exposed to UV light via a photomask on one surface of the metal foil, and for the entire surface of the photoresist film on the other surface of the metal foil to be exposed to UV light. By doing so, the entire surface of the rear surface is exposed to UV light without a photomask, thereby enabling the entire photoresist film on the rear surface to be cured.

The exposure method and photomasking method can be carried out by forming a desired pattern in accordance with conditions set with a publicly known exposure device (a photo-plotter and the like). As shown in "3, Exposure" in FIG. 1, a photomask can be disposed at fixed intervals so that prescribed through holes can be formed, and irradiation can then be carried out for a certain period of time with UV light (ultraviolet radiation) having a prescribed intensity. The intensity of the UV light can also be set as appropriate according to the thickness of the photoresist film. For example, if the thickness of the photoresist film is approximately 5 µm, the intensity of the UV light can be adjusted to approximately 50 mj/cm².

### Developing step

In the developing step shown in "4, Developing" in FIG. 1, a prescribed pattern part of the photoresist film is removed by developing. The developing method can be similar to publicly known methods. Removal of the photoresist film can also be carried out in accordance with known developing methods. For example, by dipping for approximately 1 minute in a 1% aqueous solution of Na₂CO₃ (sodium carbonate) at a liquid temperature of 30°C, it is possible to remove the photoresist film.

### Etching step

In the etching step shown in "5, Etching" in FIG. 1, through holes are formed in the metal foil by etching. That is, by dipping in an etching liquid, through holes are formed due to the metal component in the parts exposed in the developing step being dissolved. The etching liquid can be, for example, a single solution (or aqueous solution) of sulfuric acid, phosphoric acid, chromic acid, nitric acid, hydrofluoric acid, acetic acid, caustic soda, ferric chloride, cupric chloride, perchloric acid and the like, or a mixed solution of these. In the present invention, it is possible to use an etching liquid obtained by diluting the above-mentioned solutions as appropriate with a solvent such as water.

The etching conditions can be set according to publicly known etching methods. For example, the liquid temperature can be approximately 25 to 60°C, and the treatment time can be approximately 10 seconds to 5 minutes.

### Peeling step

In the peeling step, the remaining photoresist film is removed. The photoresist film canbe removed using, for example, a weakly alkaline aqueous solution. The weakly alkaline aqueous solution can be, for example, an aqueous solution of sodium hydroxide. In addition, after removing the photoresist film, a treatment such as drying the metal foil may be carried out if necessary in the present invention.

The metal foil of the present invention, which is obtained as described above, can be formed into a product by winding into a coil if necessary. Thereafter, the metal foil of the present invention may be cut to an appropriate size if necessary and supplied to a step in which an active substance is coated on the metal foil.

### EXAMPLES

The features of the present invention will now be explained in greater detail through the use of examples and comparative examples. However, the scope of the present invention is not limited to the working examples.

Moreover, the methods for measuring various physical properties were carried out as follows.

### (1) Through hole density

The surface was observed under a microscope (manufactured by Keyence Corporation), and the through hole density was measured.

### (2) Aperture ratio

An image obtained from the above-mentioned microscope (10 or more through holes were included in the field of view. If 10 or more holes were not included, the magnification ratio was altered so that 10 or more through holes were included in the field of view) was binarized using image processing software provided with the microscope, and the areal ratio of the through hole parts was measured and deemed to be the aperture ratio.

### (3) Average internal diameter of through holes

Photographs of 10 fields of view were taken at random using the same method as that used in (2) above, image analysis was carried out in order to measure the number of through holes and the total through hole area, and the internal diameters of the through holes were calculated on the assumption that all the through holes were identical circles. The image analysis device was a "PCA11" multi-purpose high-speed image analysis device (manufactured by System Science Co., Ltd.).

### Example 1

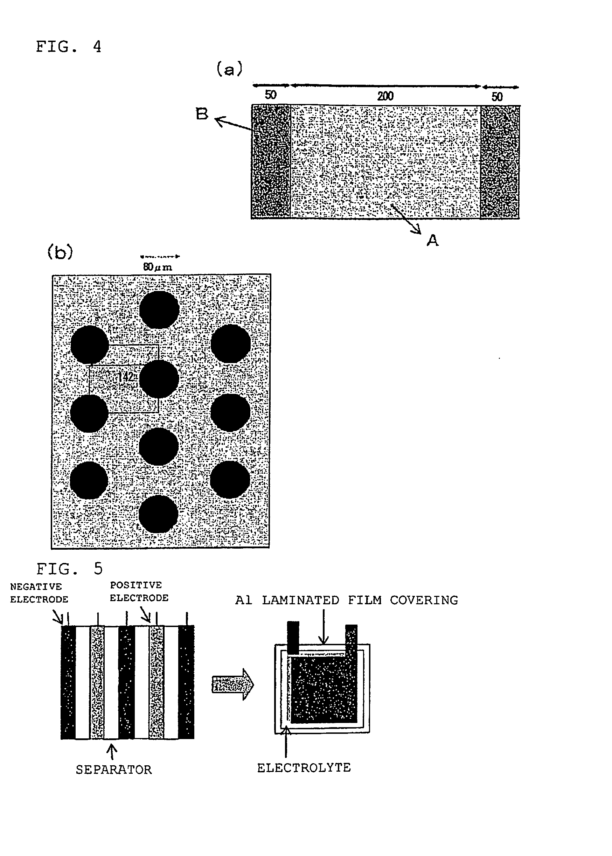

As a metal foil, a coiled electrolytic copper foil having a thickness of 10µm, a width of 300 mm and a length of 250 m was dip coated with a solution of an acrylic resin negative photoresist so as to coat both surfaces of the copper foil with the acrylic resin at a thickness of 5 µm, and the coated copper foil was then dried at 80°C. One surface of the metal foil was irradiated with UV light at an intensity of 100 mj/cm² via a photomask on which the pattern shown in FIG. 4 was drawn by means of a photo-plotter, and the whole of the other surface of the metal foil was irradiated with the above-mentioned UV light without using a photomask. As a developing step, the metal foil was dipped in a solution of sodium carbonate in order to dissolve and remove the photoresist on the photomask section. The metal foil was etched by dipping the obtained material in cupric chloride at a liquid temperature of 50°C. The dipping time was 30 seconds. Following the etching, the metal foil was dipped in a solution of sodium hydroxide (NaOH) so as to peel off the photoresist layer. Corrosion prevention treatment, washing and drying were then carried out. A metal foil for a negative electrode collector was obtained in this way.

### Comparative Example 1

A metal foil was obtained in the same way as Example 1, except that the pattern shown in FIG. 4 (b) was used and the through hole density and the average internal diameter of the through holes were as shown in Table 1.

### Test Example 1

The through hole density and the like of the metal foils for negative electrode collectors obtained in Example 1 and Comparative Example 1 were investigated. These results are shown in Table 1.

**[Table 1]**

| | Through hole density (holes/cm²) | Average internal diameter of through holes (µm) | Foil thickness/aperture ratio (µm/%) | Aperture ratio (%) |
|---|---|---|---|---|
| Example | 5000 | 80 µm φ | 0.40 | 25 |
| Comparative Example | 200 | 500 µm φ | 0.25 | 40 |

### Test Example 2

In use of the metal foils for negative electrode collectors obtained in Example 1 and Comparative Example 1, negative electrodes were prepared by cutting out the obtainedmetal foils, which have lengths of approximately 50 cm, at a part approximately 5 m and a part approximately 900 m in the length direction after the start of the etching, than coating with a slurry containing an active substance composed of carbon particles, and then cutting to sizes of 10 cm × 20 cm. Here, the coating characteristics in the above-mentioned slurry-coating step were confirmed. Next, a battery such as that shown in FIG. 5 was assembled according to the disclosures in WO 2008/078777, and the capacity (mAh) and internal resistance (mΩ) of this battery were investigated. These results are shown in Table 2. Moreover, in the battery shown in FIG. 5, the electrolyte was an organic LIC electrolyte and the electrode structure was a laminated cell type.

**[Table 2]**

| | Capacity (mAh) | Internal resistance (mΩ), | Coating characteristics | |
|---|---|---|---|---|
| Example 1 | 1.2 | 550 | ○ | No leaks |
| Conventional Example 1 | 0.9 | 900 | × | Leaks |

Moreover, the physical properties shown in Table 2 were measured as follows.

### (1) Capacity (mAh)

The above-mentioned cell was subjected to a charging and discharging test and the capacity was calculated from the discharging time. The discharging was carried out at a current of 53 mA/cm², and the capacity was calculated by multiplying the current by the discharging time required for the voltage to reach 2.2 V from 3.8 V.

### (2) Internal resistance (mΩ)

In the above-mentioned test, the internal resistance was calculated using Ohm's Law from the value of the discharging current and the value of the voltage drop that occurred when switching between charging and discharging (the IR drop).

### (3) Coating characteristics

An electrode coating liquid containing a negative electrode active substance was coated (to a thickness of 20 µm on each surface) on both surfaces of a copper collector having through holes using a die coater. A leak check (10 m) and a check for the occurrence of surface patterns (the occurrence of differences in coating thickness) were carried out as checks following coating. A case in which a leak or a surface pattern was confirmed visually was evaluated as "×" and a case in which these were not confirmed was evaluated as "○".

## Claims

1. A metal foil for a negative electrode collector, which has a plurality of through holes that reach a foil rear surface from a foil front surface and which has a region having a through hole density of 1,000 holes/cm² or more.

2. The metal foil for a negative electrode collector according to claim 1, wherein an average internal diameter of the through holes is 100 µm or lower.

3. The metal foil for a negative electrode collector according to claim 1, wherein an aperture ratio is 30% or lower.

4. The metal foil for a negative electrode collector according to claim 1, wherein 2.0 > [the foil thickness (µm)/the aperture ratio (%)] > 0.25 is established.

5. The metal foil for a negative electrode collector according to claim 1, further containing a region having a through hole density of less than 1,000 holes/cm².

6. The metal foil for a negative electrode collector according to claim 1, wherein the area of the region having a through hole density of 1,000 holes/cm² or more is 100 mm² or more.
